# EUROPEAN PATENT SPECIFICATION

(11) **EP 0 303 486 B1**
(45) Date of publication and mention of the grant of the patent: **07.05.1997**
(21) Application number: 88307442.9
(22) Date of filing: 11.08.1988
(51) Int. Cl.: H01L 21/265, H01J 37/08, H01J 37/317

(54) **Method of ion implantation**
Verfahren zur Ionenimplantation
Procédé d'implantation d'ions

(30) Priority: 12.08.1987 JP 200001/87; 12.08.1987 JP 200002/87; 19.08.1987 JP 204254/87; 31.08.1987 JP 215453/87
(43) Date of publication of application: 15.02.1989
(73) Proprietor: Oki Electric Industry Company, Limited, Tokyo 105 (JP)
(72) Inventor: Fukuda, Hisashi Oki Electric Industry Co., Ltd., Minatoku Tokyo (JP)
(74) Representative: Read, Matthew Charles

(56) References cited:
- EP-A- 0 204 297
- GB-A- 2 087 139
- GB-A- 2 150 745
- US-A- 3 763 346
- US-A- 4 686 414
- NUCLEAR INSTRUMENTS AND METHODS IN PHYSICS RESEARCH, Section B, vol. B6, no. 1/2, January 1985, pp. 135-142, Amsterdam, NL; P.D. PREWETT et al.: 'Liquid Metal Ion Sources for FIB Microfabrication Systems - Recent Advances'
- IBM TECHNICAL DISCLOSURE BULLETIN, vol. 27, no. 11, April 1985, pages 6751-6752, New York, US; 'Internal Cleaning Method for Broad Beam Ion Sources'

## Description

The present invention relates to a method and apparatus for implanting boron or arsenic ions in a substrate.

In conventional ion implantation technology used for the fabrication of semiconductor devices, a broad ion beam, ranging from several millimetres to several tens of centimetres in diameter, is directed onto a substrate which is masked by a resist pattern.

Liquid metal ion source (LMIS) technology makes use of a strong electric field to extract ions directly from the surface of molten metal. This technology offers an alternative microfabrication techniques, which do not require the use of masks, and which can be used to perform milling, etching, resist exposure, ion implantation and deposition in regions of the order of 0.1 micrometres in size.

GB-A-2087139 discloses a method of ion implantation for implanting boron or arsenic ions in a substrate, comprising holding a four element alloy including arsenic and boron in a reservoir in a molten state; supplying the four element alloy from the reservoir to an emitter; and applying a strong electric field to the tip of the emitter to extract ions from the tip of the emitter. GB-A-2087139 also discloses an ion implantation apparatus for implanting boron and/or arsenic ions in a substrate, comprising a reservoir of a molten four element alloy including arsenic and boron; an emitter having a tip; means for supplying the molten four element alloy to the emitter; and means for applying a strong electric field to the tip of the emitter to extract ions from the tip of the emitter.

When LMIS technology is used for the fabrication of silicon-based large-scale integrated circuits, it is necessary that the LMIS material includes a dopant element such as boron, arsenic or phosphorus, a metallic element such as platinum, nickel or lead for electrode formation, and an element to enable monitoring of a region to be implanted by means of a scanning ion microscope (SIM), preferably an element such as silicon which will not affect the characteristics of the device being fabricated. Among the elements mentioned above, arsenic and phosphorus have high vapour pressures and vaporize easily while boron and platinum have high melting points, resulting in small ion current densities. Consequently, it is not possible to use these elements alone as the LMIS material.

The necessary elements are, therefore, combined in eutectic alloys in which the above problems do not manifest themselves. LMIS alloys such as Au-Si, Au-Si-Be, Pd-Ni, Si-Be-B, Pt-As, Pd-As-B, Ni-B-Si, Pd-As, B-P and Cu-P are disclosed in "Journal of Vacuum Science and Technology B. vol. 5, no. 2, 1987, p469". The alloys used as LMIS materials must easily wet the emitter needle but not undergo chemical reactions with it. GB-A-2150745 also discloses a number of LMIS alloys.

Even when a eutectic alloy of elements such as palladium, nickel, boron, arsenic, silicon and phosphorus is used as the LMIS material, it has not been possible to obtain sufficient ion current because boron and arsenic are insufficiently fused into the alloy. The insufficient fusing causes arsenic to be preferentially vaporized and boron to be segregated. A further problem is that boron, nickel and palladium undergo strong chemical reactions with emitter materials such as tungsten, tantalum and molybdenum. This makes it impossible to obtain an ion current which is stable for long periods of time.

Another problem is contamination of the LMIS by sputtered atoms or residual gas during ion source operation which has also been found to reduce ion current. In particular, carbon adheres to the emitter surface LMIS operation in a FIB apparatus. The adhering carbon causes ion current to decrease by obstructing the flow of alloy on the emitter surface.

It is an aim of the present invention to overcome the aforementioned disadvantages of the prior art.

According to the present invention, the other constituents of the alloy, that is those in addition to arsenic and boron, are platinum and silicon and the emitter is formed of an alloy of tungsten and rhenium containing at least 10% rhenium by atomic composition.

In a preferred embodiment, a molten Pt-Si-As-B alloy with an atomic composition of at least 10% arsenic and 10% boron is held in a reservoir. The alloy is supplied from the reservoir to the emitter and a strong electric field is applied to the tip of the emitter to extract ions at the emitter tip. A W-Re alloy is used as the emitter material to suppress chemical reactions with the molten alloy.

Since the alloy of Pt-Si-As-B is used as the LMIS material for the FIB, continuous implantation of boron and arsenic ions is possible. Implantation of platinum ions further enables electrode formation where necessary. Emission of silicon ions is also possible, so SIM observations can be carried out without affecting device properties. In addition, since W-Re alloy is used as the emitter material, reactions with the Pt-Si-As-B alloy are suppressed and a stable ion current is obtained over a long period.

An embodiment of the present invention will now be described with reference to the accompanying drawings, in which:
Fig. 1 is a schematic representation of the ion source in an FIB system;
Fig. 2 illustrates an arrangement of electrodes for measuring emitted ion current; and
Fig. 3 is a graph showing the extraction-voltage/emitted-ion-current characteristic.

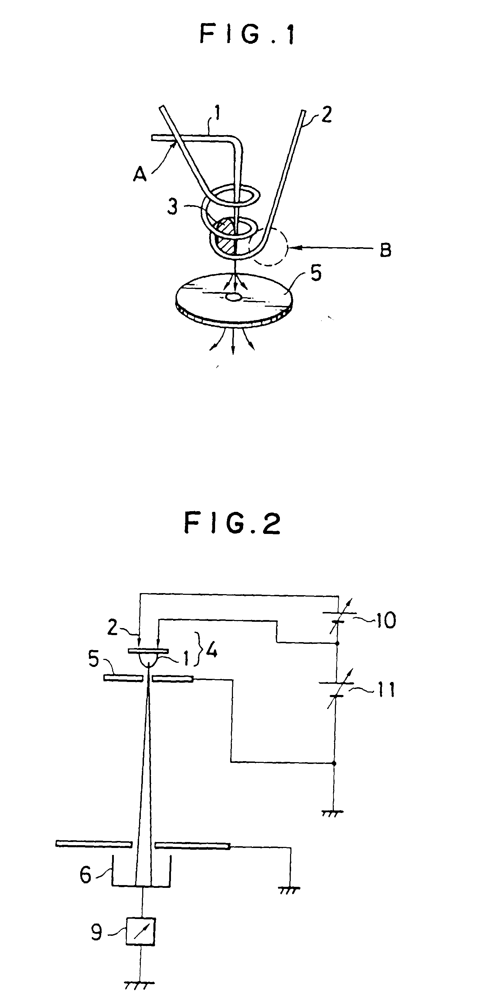

Referring to Fig. 1, an FIB apparatus comprises an emitter 1, a heater 2, and an LMIS material 3. The emitter tip 1 and the heater 2 are both fabricated from 0.2mm diameter wire having an atomic composition of 75% tungsten and 25% rhenium and are spot-welded together at point A. The tip of the emitter 1 protrudes 0.5mm beyond the heater 2, the space between the tip of the emitter 1 and the heater 2 being approximately 2mm. The LMIS material comprises a eutectic Pt-Si-As-B alloy [Pt:Si:As:B = 4:4:1:1 atom percent].

The Pt-Si-As-B alloy can be fabricated by the following procedure. Weigh the constituent elements and vacuum-seal them in a quartz tube. Heat the tube to 1000°C and mix the elements. After mixing, oven-anneal the mix at 800°C to 1000°C for 30 to 50 hours to obtain a uniform composition.

Application of this LMIS material 3 to the heater 2, which heats it to a temperature of 800°C, and application of an electric field of 10GVm⁻¹ (1V/Å) to the tip of the emitter 1 extracts boron ions, which become acceptors in the silicon substrate, and arsenic ions, which become donors. The boron ions and arsenic ions are implanted selectively by means of a conventional mass separator (not shown), such as a Wien filter.

Referring to Fig. 2, an apparatus for measuring emitted ion current comprises an ion source 4, as shown in Fig. 1, an extraction electrode 5, a Faraday cup 6, an ammeter 9, a power supply 10 for heating the heater of the ion source 4 and a power supply 11 for accelerating the ions. The electrodes are arranged to measure the ion current emitted within an angle of 1°. This apparatus was used to measure the current at the Faraday cup 6 for different extraction voltages applied to the extraction electrode 5 with a Pt-Si-As-B alloy as the LMIS material.

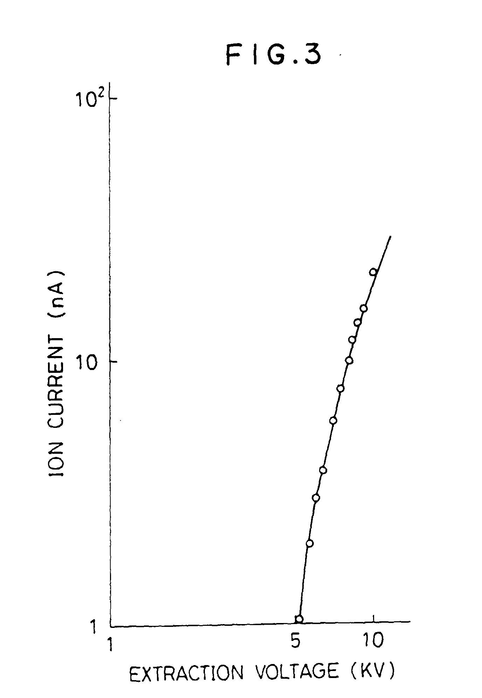

Referring to Fig. 3, the extraction voltage is on the x-axis and the ion current is on the y-axis. As a result of the use of an emitter material with an atomic composition of 95% tungsten and 5% rhenium with this Pt-Si-As-B material, in two hours of operation reaction between the emitter material and the LMIS material caused the heater wire to break at the point B, indicated in Fig. 1. When the proportion of rhenium was 10% by atomic composition or more, degradation of the ion source due to breaking of the wire did not occur.

Thus, when ion implantation is performed using a focused ion beam with a Pt-Si-As-B alloy LMIS material and W-Re alloy emitter, the ion implantation can be performed for a long period at a high ion current density. In addition, continuous implantation of acceptor boron ions and donor arsenic ions into a silicon substrate is possible. Moreover, platinum ions can be implanted to form electrodes where required. It is also possible to emit silicon ions for making SIM observations without affecting the characteristics of the device being fabricated.

The use of a eutectic Pt-Si-As-B alloy as the FIB LMIS material enables selective implantation of platinum ions, silicon ions, arsenic ions and boron ions in microscopic regions with a high ion current density. Use of a W-Re alloy for the emitter material prevents degradation of the emitter and enables ion implantation to be carried out for extended times.

## Claims

1. A method of ion implantation for implanting boron and/or arsenic ions in a substrate, comprising:
holding a four element alloy including arsenic and boron in a reservoir in a molten state;
supplying the four element alloy (3) from the reservoir to an emitter (1); and applying a strong electric field to the tip of the emitter (1) to extract ions from the tip of the emitter (1),
**characterized in that** the other constituents of the alloy (3) are platinum and silicon and the emitter (1) is formed of an alloy of tungsten and rhenium containing at least 10% rhenium by atomic composition.

2. An ion implantation apparatus for implanting boron and/or arsenic ions in a substrate, comprising:
a reservoir of a molten four element alloy (3) including arsenic and boron; an emitter (1) having a tip;
means for supplying the molten four element alloy (3) to the emitter; and means (11) for applying a strong electric field to the tip of the emitter (1) to extract ions from the tip of the emitter (1),
**characterized in that** the other constituents of the alloy (3) are platinum and silicon and the emitter (1) is formed of an alloy of tungsten and rhenium containing at least 10% rhenium by atomic composition.

## Patentansprüche

1. Ionenimplantationsverfahren zum Implantieren von Bor- und/oder Arsen-Ionen in ein Substrat, welches folgendes umfaßt:
eine Legierung aus vier Elementen, die Arsen und Bor einschließen, in einem Reservoir in einem geschmolzenen Zustand zu halten;
die Legierung aus vier Elementen (3) aus dem Reservoir einer Emissionseinrichtung (1) zuzuführen; und
ein starkes elektrisches Feld an die Spitze der Emissionseinrichtung (1) anzulegen, um Ionen aus der Spitze der Emissionseinrichtung (1) zu extrahieren,
**dadurch gekennzeichnet, daß** die anderen Bestandteile der Legierung (3) Platin und Silizium sind und daß die Emissionseinrichtung (1) aus einer Legierung aus Wolfram und Rhenium gebildet ist, die in der Atomzusammensetzung wenigstens 10% Rhenium enthält.

2. Ionenimplantationsgerät zum Implantieren von Bor- und/oder Arsen-Ionen in ein Substrat, enthaltend:
ein Reservoir mit einer geschmolzenen Legierung aus vier Elementen (3), die Arsen und Bor einschließen;
eine Emissionseinrichtung (1), die eine Spitze aufweist;
eine Einrichtung, um die geschmolzene Legierung aus vier Elementen (3) der Emissionseinrichtung zuzuführen; und eine Einrichtung (11), um ein starkes elektrisches Feld an die Spitze der Emissionseinrichtung (1) anzulegen, um !onen aus der Spitze der Emissionseinrichtung (1) zu extrahieren,
**dadurch gekennzeichnet, daß** die anderen Bestandteile der Legierung (3) Platin und Silizium sind und daß die Emissionseinrichtung (1) aus einer Legierung aus Wolfram und Rhenium gebildet ist, die in der Atomzusammensetzung wenigstens 10% Rhenium enthält.

## Revendications

1. Procédé d'implantation d'ions pour implanter des ions bore et/ou arsenic dans un substrat, comprenant :
le maintien d'un alliage de quatre éléments incluant de l'arsenic et du bore dans un réservoir, dans un état fondu ;
la fourniture de l'alliage de quatre éléments (3) depuis le réservoir jusqu'à un émetteur (1) ;
et l'application d'un champ électrique fort au bout de l'émetteur (1) pour extraire des ions du bout de l'émetteur (1),
**caractérisé en ce que** les autres constituants de l'alliage (3) sont le platine et le silicium et en ce que l'émetteur (1) est formé d'un alliage de tungstène et de rhénium contenant au moins 10 % de rhénium en composition atomique.

2. Appareil d'implantation d'ions pour implanter des ions bore et/ou arsenic dans un substrat, comprenant :
un réservoir d'un alliage de quatre éléments (3) fondu incluant de l'arsenic et du bore ;
un émetteur (1) ayant un bout ;
des moyens pour fournir l'alliage de quatre éléments (3) fondu à l'émetteur ;
et des moyens (11) pour appliquer un champ électrique fort au bout de l'émetteur (1) pour extraire des ions du bout de l'émetteur (1),
**caractérisé en ce que** les autres constituants de l'alliage (3) sont le platine et le silicium et en ce que l'émetteur (1) est formé d'un alliage de tungstène et de rhénium contenant au moins 10 % de rhénium en composition atomique.
